**Europäisches Patentamt**

**European Patent Office**

**Office européen des brevets**

(19)

(11) Veröffentlichungsnummer : **0 676 791 B1**

(12)

# EUROPÄISCHE PATENTSCHRIFT

(45) Veröffentlichungstag der Patentschrift :
**15.11.95 Patentblatt 95/46**

(51) Int. Cl.$^6$ : **H01J 37/34**

(21) Anmeldenummer : **94105388.6**

(22) Anmeldetag : **07.04.94**

(54) **Magnetronzerstäubungsquelle und deren Verwendung.**

(43) Veröffentlichungstag der Anmeldung :
**11.10.95 Patentblatt 95/41**

(45) Bekanntmachung des Hinweises auf die
Patenterteilung :
**15.11.95 Patentblatt 95/46**

(84) Benannte Vertragsstaaten :
**AT CH DE FR GB IT LI NL SE**

(56) Entgegenhaltungen :
**EP-A- 0 558 797**
**WO-A-92/04483**

(73) Patentinhaber : **BALZERS
AKTIENGESELLSCHAFT
FL-9496 Balzers (LI)**

(72) Erfinder : **Grünenfelder, Pius
Buelweg
CH-7323 Wangs (CH)**
Erfinder : **Hirscher, Hans, Dr., Dipl.-Physiker
Sandstrasse 3
CH-7310 Bad Ragaz (CH)**
Erfinder : **Schwendener, Urs
Erbweg 7
CH-9470 Buchs (CH)**
Erfinder : **Haag, Walter, Dipl.-Ing.
Buchenweg 2
CH-9472 Grabs (CH)**

(74) Vertreter : **Troesch Scheidegger Werner AG
Patentanwälte,
Siewerdtstrasse 95,
Postfach
CH-8050 Zürich (CH)**

EP 0 676 791 B1

## Beschreibung

Die vorliegende Erfindung betrifft eine Magnetronzerstäubungsquelle nach dem Oberbegriff von Anspruch 1 sowie deren Verwendung nach Anspruch 20.

Bezuglich Magnetronzerstäubungsquellen generell wird verwiesen auf:
- die DE-OS-24 31 832,
- die EP-A-0 330 445,
- die EP-A-0 311 697,
- die US-A-5 164 063,
- die DE-PS-40 18 914.

Aus der DE-PS-35 06 227 derselben Anmelderin wie vorliegende Anmeldung ist eine Magnetronzerstäubungsquelle bekannt geworden mit einem oder zwei Targetkörpern, welche eine zentrisch spiegelsymmetrisch konkav ausgebildete Zerstäubungsfläche bilden.

Ein Werkstück wesentlich kleineren Durchmessers als der Durchmesser des topfförmigen Targetkörpers in Aufsicht wird mittels einer Halterung zur Zerstäubungsbeschichtung eingebracht. Es sind magnetische Kreise vorgesehen - worunter verstanden sei eine Anordnung aus aktiven Elementen, wie aus Permanent- und-/oder Elektromagneten, sowie aus passiven Elementen, wie aus ferromagnetischen Elementen, beispielsweise aus Eisenjochteilen und Luftspalten -, welche ein Magnetfeld der bei Magnetrons grundsätzlich bekannten Art erzeugen. Die magnetischen Kreise sind je separat für den Bodenbereich der Zerstäubungsfläche und deren aufgewölbten Randbereich wirksam.

Aus der DE-A-28 24 289 ist es bekannt, die Zerstäubungsfläche eines Targetkörpers an einer Magnetronzerstäubungsquelle zentrisch konkav auszubilden und im Randbereich des Targetkörpers einen Erdabschirmungsrahmen vorzusehen. Die Anode ist bezüglich des Targetkörpers zentrisch angeordnet und mediumsgekühlt. Bei dieser Quelle wird ein zu beschichtendes Werkstück allgemein oberhalb der dargestellten Quelle angeordnet, d.h. oberhalb des Erdabschirmungsrahmens, welcher den Rand des Targetkörpers umgibt.

Aus der EP-A-0 393 957 ist ebenfalls eine Magnetronzerstäubungsquelle mit zentrisch konkav eingeformter Zerstäubungsfläche des Targetkörpers bekannt, bei welcher ein zerstäubungszubeschichtendes Werkstück weitab von der Quelle angeordnet ist.

Nun ist es in vielen Fällen, und gerade in der auch gemäss vorliegender Erfindung bevorzugten Verwendung der Magnetronzerstäubungsquelle für die Beschichtung von Speicherplatten, wie z.B. von optischen Speicherplatten, wie beispielsweise magnetooptischen Platten, Bildplatten oder von Audioplatten, wie beispielsweise Compact Disks, ein Bedürfnis, kurze Beschichtungszeiten bei langen Standzeiten der eingesetzten Targetkörper zu erreichen, was unter anderem bedingt, dass ein möglichst hoher Anteil des von der Zerstäubungsquelle abgestäubten Materials auch als Schichtmaterial auf die zu beschichtende Werkstückoberfläche abgelegt wird.

Unter diesem Aspekt weisen die in den letzterwähnten Schriften beschriebenen Zerstäubungsquellen den Nachteil auf, dass, unter anderem wegen der grossen Flächen, die weder Zerstäubungsfläche der Zerstäubungsquelle sind noch nutzzubeschichtende Fläche eines Werkstückes, ein relativ hoher Prozentsatz des von der Zerstäubungsfläche des Targets abgestäubten Materials sich unnütz an übrigen, den Prozessraum definierenden Flächen ablegt, was die vorerwähnte Ausbeute drastisch reduziert. Damit wird aber die Beschichtungsgeschwindigkeit sowie die Standzeit eines Targetkörpers massgeblich reduziert, indem pro Targetkörper weniger Werkstücke mit gegebener Schichtdicke beschichtet werden können.

Ausserdem sind mehr Reinigungsintervalle notwendig, um die Betriebssicherheit zu gewährleisten. Im weiteren sind zur Realisierung erwünschter Raten hohe Betriebsleistungen erforderlich, die ihrerseits die thermische Belastung der Quelle und der Werkstücke erhöhen. All dies schlägt sich negativ auf die Wirtschaftlichkeit einer Produktionsanlage nieder.

Die erwähnten Nachteile gelten auch für die aus der DE-A-42 02 349 bekannte Magnetronzerstäubungsquelle. Sie weist einen zentrisch konkav ausgebildeten Targetkörper auf, eine Magnetkreisanordnung, welche über der Zerstäubungsfläche ein Magnetfeld erzeugt, eine Anodenanordnung, einen um den Rand des Targetkörpers umlaufenden, diesbezüglich elektrisch isolierten Aufnahmerahmen mit Aufnahmeöffnung für eine zu beschichtende Werkstückscheibe, wobei der Prozessraum, im wesentlichen, durch die Zerstäubungsfläche des Targetkörpers und die Innenfläche des Aufnahmerahmens definiert ist und, im Betrieb, abgeschlossen ist durch die auf die Aufnahmeöffnung des Aufnahmerahmens gelegten Werkstückscheibe.

Unter Berücksichtigung der Tatsache, dass der Aufnahmerahmen als Beispiel einer umlaufenden nichtzerstäubten Restinnenfläche aussen um den Rand des Targetkörpers umläuft, ergibt die bereits im Querschnitt ersichtliche Schnittlänge der Rahmeninnenfläche eine grosse Ringfläche als weder nutzzerstäubte noch nutzbeschichtete Fläche. Sie ist nicht wesentlich kleiner als die Zerstäubungsneufläche des Targetkörpers, aber grösser als die Fläche der Aufnahmeöffnung. Damit wird ein hoher Prozentsatz der die Innenfläche des Prozessraumes berandenden Wandungen wohl beschichtet, aber nicht nutzbeschichtet, womit die erwähnte Wirtschaftlichkeit schlecht ist.

Es ist Aufgabe der vorliegenden Erfindung, die erwähnten Nachteile bezüglich Wirtschaftlichkeit zu beheben.

Dies wird, ausgehend von einer Magnetronzerstäubungsquelle eingangs genannter Art, durch deren Ausbildung nach dem kennzeichnenden Teil von Anspruch 1 erreicht.

Dadurch, dass erfindungsgemäss die Zerstäubungsfläche des Targetkörpers den Prozessraum im wesentlichen definiert - abgesehen von dem im Betrieb aufgelegten Werkstück -, ergibt sich primär eine wesentliche Verbesserung des Verhältnisses zwischen abgestäubter Materialmenge und als Schicht am Werkstück oder den Werkstücken abgelegter Materialmenge, was nun zu einer wesentlichen Erhöhung der genannten Wirtschaftlichkeit führt.

Bevorzugte Flächenverhältnisse ergeben sich nach dem Wortlaut von Anspruch 2.

Bevorzugte Ausführungsformen der erfindungsgemässen Magnetronzerstäubungsquelle sind in den Ansprüchen 2 bis 19 spezifiziert.

Die Erfindung wird anschliessend beispielsweise anhand von Figuren dargestellt.

Es zeigen:

Fig. 1     eine vereinfachte Querschnittsdarstellung einer bevorzugten erfindungsgemässen Magnetronzerstäubungsquelle;

Fig. 2     die gleiche Darstellung wie Fig. 1, ergänzt mit den vorgesehenen magnetischen Kreisen.

Anhand der folgenden Beschreibung dieses Ausführungsbeispiels werden auch Varianten bezüglich Aufbaus der erfindungsgemässen Quelle erläutert.

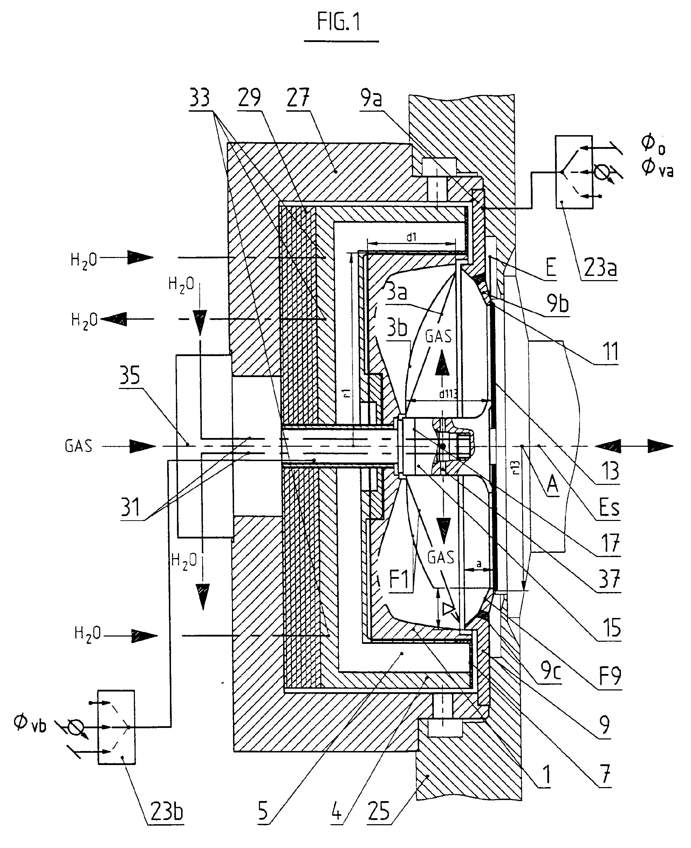

Gemäss Fig. 1 weist die erfindungsgemässe Magnetronzerstäubungsquelle einen Targetkörper 1 auf, dessen Zerstäubungsfläche im Neuzustand 3 konisch, wie bei 3a dargestellt, oder hohlspiegelförmig, vorzugsweise in Form einer Kugelkalotte, wie bei 3b dargestellt, ausgebildet ist, so dass der Targetkörper 1 schon im Neuzustand am Rande wesentlich dicker ist als im Zentrum. Obwohl in der bevorzugten Realisationsform, die dargestellt ist, das Target in Aufsicht kreisförmig ist und mithin seine konkave Einformung rotationssymmetrisch ist, kann für gewisse Einsatzzwecke der Targetkörper 1 und die nachfolgenden noch zu beschreibenden Konstruktionselemente der Quelle bezüglich einer einzigen oder zweier Ebenen symmetrisch ausgebildet sein.

Der Targetkörper 1 und mithin die weiteren Konstruktionselemente der Quelle definieren bevorzugterweise eine rechteckförmige Magnetronquelle oder eine elliptische oder generell ovale oder, in der dargestellten, besonders bevorzugten Ausführungsvariante, eine kreisförmige Magnetronquelle.

Bei einer kreisförmigen Quelle, wie dargestellt, beträgt die maximale Dicke $d_1$ des Targetkörpers 1 an seinem Rand ca. 50% des Targetradius $r_1$.

Der Targetkörper 1 ist in einem ferromagnetischen, topfförmigen Magnetkreisgehäuse 4 eingelassen, welches einen topfförmigen Magnetaufnahmeraum 5 definiert, der den Targetkörper 1 basisseitig und an seinen hochragenden Seitenflächen umschliesst. Entlang des Randes des Targetkörpers 1 und der kreisringförmigen Abschlussstirnfläche 7 des Magnetkreisgehäuses 4 ist, auf Dunkelraumabstand und von Targetkörper 1 sowie Gehäuse 4 elektrisch isoliert, ein umlaufender Aufnahmerahmen 9 vorgesehen. Seine Innenfläche $F_9$ ragt, geneigt, vom Rand des Targetkörpers 1 gegen die Zentrumsachse A der Quelle einwärts und definiert eine Aufnahmeöffnung 11 für, in der dargestellten Ausführungsform, eine kreisförmige Werkstückscheibe 13. Beim dargestellten Beispiel ist das Verhältnis der Fläche $F_9$ zur Zerstäubungsneufläche $F_1$:

$$F_9 \cong 30\% \ F_1.$$

Bei der kreisförmigen Werkstückscheibe 13 handelt es sich vorzugsweise um eine dielektrische oder metallische Werkstückscheibe, vorzugsweise um den zu beschichtenden Körper einer Speicherscheibe, wie einer magnetooptischen Speicherplatte, einer Bildplatte, einer Audioplatte, vorzugsweise aber um den zu beschichtenden Körper einer Compact Disk, CD. Die Scheibe 13 liegt an ihrer Peripherie am Rande der Aufnahmeöffnung 11 auf dem Aufnahmerahmen 9 auf, welcher, insbesondere im Falle der CD-Bearbeitung, das periphere Maskierungsorgan bildet, um am Rande der Scheibe eine Zerstäubungsbeschichtung zu verhindern und einen um einen möglichst scharfen Uebergang von beschichteter Fläche zu unbeschichtetem Rand zu erzielen.

Im Zentrum kann der Targetkörper 1 von einem diesbezüglich elektrisch isolierten Kern 15 durchdrungen sein, was aber zur Realisation der erfindungsgemässen Quelle nicht notwendig ist. Der Kern 15 ist für die CD-Beschichtung und für die Beschichtung der meisten anderen optischen Speicherplatten bis auf das Niveau der Aufnahmeöffnungsebene E geführt, um das Zentrum der Werkstückscheibe zu maskieren. Ist dies nicht notwendig, so kann der Kern 15, wie mit der Abschlussfläche 17 angedeutet, höhenreduziert oder ganz weggelassen sein.

Der Targetkörper 1 wird mit dem Magnetkreisgehäuse 4 auf negatives kathodisches Potential gelegt. Sowohl der Kern 15 wie auch der Aufnahmering 9 können, wie mit den Wahleinheiten 23a, 23b schematisch dargestellt, auf Anode, z.B. Massepotential $\Phi_0$, oder auf einstellbare oder fix vorgegebene andere Bezugspoten-

EP 0 676 791 B1

tiale $\Phi_v$ gelegt werden oder können je floatend betrieben werden. Bevorzugterweise werden Kern 15 und Ring 9 auf anodische Potentiale gelegt.

Wie z.B. mit dem Isolationsring 9c dargestellt, ist es durchaus möglich, zwei oder mehr Teile 9a, 9b des Aufnahmerahmens 9 vorzusehen und gegebenenfalls elektrisch unterschiedlich zu betreiben, beispielsweise den Teil 9a auf anodisches Potential zu legen, einen Teil 9b floatend zu betreiben.

Bei einer kreisförmigen Werkstückscheibe 13 mit Radius $r_{13}$, entsprechend einem Durchmesser $\varnothing\,13 = 2r_{13}$, hat sich die folgende Dimensionierung des maximalen Abstandes der Zerstäubungsneufläche von der zu beschichtenden Scheibenoberfläche, $d_{113}$, ausgezeichnet bewährt:
- $d_{113} \geqq 20\%\ \varnothing_{13}$,

wobei der Abstand $d_{113}$, insbesondere bei den üblichen Druckverhältnissen beim Zerstäubungsbeschichten von $10^{-3}$ bis $10^{-1}$ mbar, 25mm nicht oder nicht wesentlich unterschreiten sollte.

Im weiteren gilt bevorzugterweise:
- $d_{113} \leqq 50\%\ \varnothing_{13}$, bevorzugt wird:
- $d_{113} \leqq 42\%\ \varnothing_{13}$,

und dabei insbesondere bevorzugt wird die Vermassung:
- $d_{113} \leqq 35\%\ \varnothing_{13}$.

Dies gilt insbesondere für die Bearbeitung von kreisscheibenförmigen Werkstücken mit Durchmessern von 50mm bis 150mm, insbesondere dabei von 75mm bis 150mm.

Handelt es sich nicht um kreisscheibenförmige Werkstücke, die beschichtet werden sollen, sondern beispielsweise um ovale oder rechteckförmige, so gelten die angegebenen Dimensionierungsvorschriften mit Bezug auf den kleinsten Durchmesser $\varnothing_k$ des jeweiligen Werkstückes.

Im weiteren gilt bevorzugterweise, insbesondere für die Ausführungsform für CD-Beschichtung gemäss der Figur, dass der Radius $r_1$ des Targetkörpers 30% bis 40% grösser ist als der Radius $r_{13}$ der zu beschichtenden Werkstückscheibe 13.

Die geneigt minimalisierte Innenfläche $F_9$ des Aufnahmeringes 9, welche weder nutzzerstäubt noch nutzbeschichtet wird und plasmatechnisch die Entladungsstabilität im Randbereich zwischen Scheibenperipherie und Targetkörperrand gewährleistet, ist bevorzugterweise gemäss folgenden Dimensionierungsvorschriften ausgelegt:

Die bezüglich der Achse A oder, generell, bezüglich einer Symmetrieebene $E_S$ senkrechte, durch die Fläche $F_9$ überbrückte Distanz $\Delta$ beträgt, bezüglich des Durchmessers $\varnothing_{13}$ einer Kreisscheibe 13 oder, allgemeiner, bezüglich des kleinsten Durchmessers $\Phi_k$ einer Nichtkreisscheibe, wie oben definiert:
- $\Delta \leqq 20\%\ \varnothing_{13}$, beträgt dabei bevorzugterweise
- $\Delta \leqq 10\%\ \varnothing_{13}$

und wird bevorzugterweise zu
- $\Delta \approx 15\%\ \varnothing_{13}$ dimensioniert.

Dabei ist es durchaus möglich, die Distanz $\Delta$ zu Null zu wählen, d.h. die Innenfläche $F_9$ nur mit Komponenten parallel zur Achse A bzw. der Ebene $E_S$ auszulegen.

Die durch die Innenfläche $F_9$ überstrichene Distanz a, parallel zur Achse A bzw. Ebene $E_S$, beträgt, unabhängig davon, ob $\Delta$ überhaupt grösser als 0 ist oder nicht, und bezogen auf den Abstand $d_{113}$, zwischen Zerstäubungsneuflächenzentrum und zu beschichtender Scheibenfläche:
- $0 \leqq a \leqq 50\%\ d_{113}$, beträgt dabei bevorzugterweise
- $0 \leqq a \leqq 40\%\ d_{113}$, und wird bevorzugterweise dimensioniert zu
- $a \approx 30\%\ d_{113}$.

Im weiteren ist in der Figur mit 25 ein anlagenseitiger Flansch zur Montage der erfindungsgemässen Quelle dargestellt. Zwischen einem Quellengehäuse 27 mit dem Flansch 25 und der Magnetkreisgehäuse- / Targetkörperanordnung 4/1 ist eine elektrische Isolation 29 vorgesehen. Wie schematisch dargestellt, ist weiter der zentrische Kern 15 über ein Leitungssystem 31 mediums-, vorzugsweise wassergekühlt. Die Kühlung des Aufnahmerahmens 9 erfolgt über den Flansch 25.

Die Kathoden/Anodenentladungsstrecke kann mit AC- und DC-Gemischtversorgung betrieben werden, beispielsweise mit getaktetem DC, oder kann rein DC-mässig betrieben werden. Es können, reaktiv oder nicht reaktiv, Schichten abgelegt werden, vorzugsweise ab elektrisch leitendem Targetkörpermaterial.

Wie weiter schematisch mit dem Leitungssystem 33 im Magnetkreisgehäuse 4 dargestellt, wird letzteres und der Targetkörper 1 mediumsgekühlt, vorzugsweise wassergekühlt.

Ein Arbeitsgas, sei dies, für nicht reaktives Zerstäubungsbeschichten, ein Edelgas oder, für reaktives, ein Edelgas mit einem Reaktivgas, welch letzteres mit dem vom Targetkörper 1 abgestäubten Material reagiert und die Beschichtung mit einem Reaktionsprodukt erfolgt, wird bevorzugterweise durch ein schematisch dargestelltes Leitungssystem 35 im Kern 15, über Auslassöffnungen 37, in den Prozessraum ausgelassen.

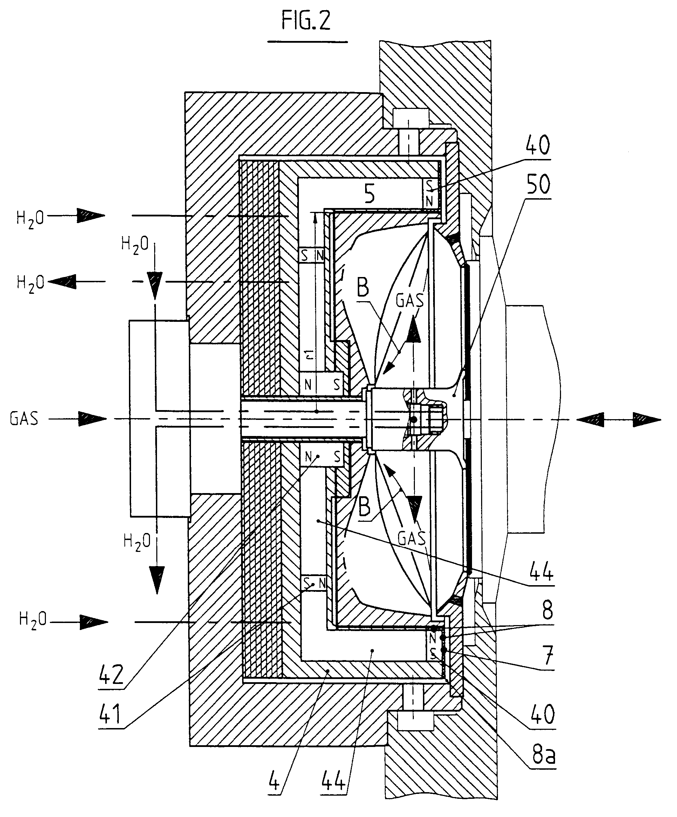

In Fig. 2, welche aus Uebersichtsgründen die gleiche Darstellung zeigt wie Fig. 1, ist der bevorzugterweise realisierte magnetische Kreis im Gehäuse 4 eingetragen. Im Bereich der Stirnfläche 7 des ferromagnetischen Gehäuses 4 ist ein Kranz von Permanentmagneten 40 vorgesehen. Im Zentrum und ca. auf halbem Radius $r_1$ der Zerstäubungsfläche sind weitere Permanentmagnetkränze 42 bzw. 41 vorgesehen. Dies ist die bevorzugte Konstellation.

Die Polaritäten der Kranzmagnete sind, wie eingetragen, so gewählt, dass qualitativ das in Fig. 2 dargestellte Magnetfeld B über der Zerstäubungsfläche entsteht und im wesentlichen, bei zunehmender Zerstäubung, bezüglich der momentanen Zerstäubungsfläche gleich stark und gleich gerichtet bleibt. Selbstverständlich ist es ohne weiteres möglich, beispielsweise durch mechanisches Nachführen des Magnetkranzes 40 und-/oder 41, das Magnetfeld während der Zerstäubung optimiert der jeweiligen momentanen Zerstäubungsfläche nachzuführen. Die Stirnfläche 7 ist mit einer Lage 8 aus nicht ferromagnetischem Material, vorzugsweise aus Isolationsmaterial, wie hochtemperaturfestem und vakuumtauglichem Kunststoff abgedeckt. Diese liegt einerseits gegen den Dunkelraum 8a, anderseits über dem einen Magnetpol N. Damit können in diesem Bereich parasitäre Plasmaentladungen und Ueberschläge verhindert werden, welche im Dunkelraum durch starke Magnetfelder ausgelöst werden könnten.

Mit dem erfindungsgemäss ausgebildeten Magnetfeld B wird auch sichergestellt, dass auch am Rande des Targetkörpers 1 möglichst abgestäubt wird und dort ein Aufstäuben weitgehend verhindert wird. Ebenfalls wird im Zentrum des Targetkörpers 1 die Zone, an welcher nicht abgestäubt wird, minimal gehalten, ebenfalls die Menge aufgestäubten Materials.

Zur Ausbildung des Magnetfeldes B gemäss Fig. 2 tragen massgeblich bei die in den Hohlraum 5 vorgesehenen aktiven Elemente 40, 41, 42 und die nicht aktiven Elemente, wie das Eisengehäuse 4 und die geometrische Anordnung mit ihren Luftspalten 44.

Weil der Aufnahmerahmen 9 gemäss Fig. 1 in weiten Grenzen elektrisch beliebig betrieben werden kann und eine Zentrumsmaskierung auch mit einer Zentrumsmaske 50 realisiert werden kann, ohne Vorsehen eines Kerns 15, ist es durchaus möglich, den die Randmaskierung realisierenden Rahmen 9 in geänderter Bauform und/oder die Zentrumsmaske 50, wie dies in der DE-Anmeldung Nr. 42 35 678 derselben Anmelderin ausführlich erörtert ist, zusammen mit der Werkstückscheibe in jeweilige Beschichtungsposition zu bringen.

Mit einer wie beispielsweise dargestellt realisierten Magnetronsputterquelle mit:

- Targetdurchmesser:            160mm
- Substratdurchmesser:            120mm
- Target/Substratabstand $d_{113}$:            35mm
- Zerstäubungsneuflächenform:            konkav, Kugelschale mit r = 80mm
- Leistungsversorgung:            15kW
- Permanentmagnete:            aus Neodym, Ferrit
- Druck:            ca. $10^{-2}$mbar
- Targetmaterial:            Al (Mg, Si, Mn)

wurden Standzeiten von 80'000 beschichteten CDs erreicht, entsprechend 220kWh.

Die spezifische Beschichtungsrate, definiert als Beschichtungsrate pro Leistungseinheit (kW), betrug bei Zerstäubungsneufläche 7nm/kWs und am Ende der Standzeit noch 4,5nm/kWs. Die Beschichtung wurde mit einer Dicke von 55nm vorgenommen.

52% des vom Targetkörper abgestäubten Materials gelangte als Schichtmaterial auf die Werkstückscheiben. Die äussere Randzone des Targetkörpers, welche nicht abgestäubt wurde, betrug: 3mm.

Im Zentrum betrug diese Zone weniger als 1mm, meistens 0mm.

Die maximale Aufstäubungsmenge über die Targetlebensdauer bzw. Standzeit betrug in diesen Zonen ca. 500µm.

Damit wird mit der erfindungsgemässen Magnetronquelle eine hohe mittlere Beschichtungsrate bei langen Standzeiten erreicht, bei ausgezeichnet gleichförmiger Flächenbeschichtung, hohem Wirkungsgrad, sei dies definiert als Beschichtungsmenge pro zerstäubte Materialmenge oder sei dies definiert als Schichtmenge pro elektrische Energieeinheit, wobei alle Prozessparameter während der Standzeit des Targetkörpers im wesentlichen konstant gehalten werden konnten.

Die spezifische Beschichtungsrate wurde praktisch bis zu einem Faktor 2 gegenüber bekannten Quellen erhöht.


## Patentansprüche

1. Magnetronzerstäubungsquelle mit einem Targetkörper (1), dessen Zerstäubungsfläche (3) vom Körperrand bezüglich mindestens einer Ebene spiegelsymmetrisch konkav ausgebildet ist, mit einer Magnetkreisanordnung (4, 40, 41, 42, 44), welche über der Zerstäubungsfläche (3) ein Magnetfeld (B) erzeugt, weiter mit einer Anodenanordnung (15, 9), einem um den Rand des Targetkörpers (1) umlaufenden, diesbezüglich elektrisch isolierten Aufnahmerahmen (9) mit Aufnahmeöffnung (11) für mindestens ein zu beschichtendes Werkstück (13), wobei, quellenseitig, der Prozessraum im wesentlichen ausschliesslich durch die Zerstäubungsfläche (3) des Targetkörpers (1) und die Innenfläche ($F_9$) des Aufnahmerahmens (9) begrenzt ist, dadurch gekennzeichnet, dass der Prozessraum - abgesehen von einer Aufnahmeöffnung (11) für mindestens ein Werkstück (13) - im wesentlichen durch die Zerstäubungsfläche (3) begrenzt ist, die umlaufende, nichtzerstäubte Restinnenfläche ($F_9$) auf das jeweilige Minimum reduziert ist, welches, im Betrieb, eine stabile Plasmaentladung gewährleistet.

2. Quelle nach Anspruch 1, dadurch gekennzeichnet, dass für die Restinnenfläche ($F_9$), wie z.B. diejenige des Aufnahmeringes (9) und die Zerstäubungsfläche $F_1$ des Targetkörpers gilt:
- $F_9 \leqq 50\% F_1$, vorzugsweise gilt
- $F_9 \leqq 40\% F_1$, insbesondere gilt
- $F_9 \leqq 30\% F_1$.

3. Quelle nach einem der Ansprüche 1 oder 2, dadurch gekennzeichnet, dass die Magnetkreisanordnung (4, 40, 41, 42, 44) auf das elektrische Potential des Targetkörpers (1) geschaltet ist.

4. Quelle nach einem der Ansprüche 1 bis 3, dadurch gekennzeichnet, dass die Zerstäubungsneufläche (3) richtend gegen die Aufnahmeöffnung (11) ausgebildet ist, beispielsweise als Paraboloid- oder Kugelfläche.

5. Quelle nach einem der Ansprüche 1 bis 4, dadurch gekennzeichnet, dass die Zerstäubungsfläche in Aufsicht kreisrund, oval oder rechteckförmig ist, vorzugsweise kreisrund.

6. Quelle nach einem der Ansprüche 1 bis 5, dadurch gekennzeichnet, dass der magnetische Kreis so ausgebildet ist, dass die Zerstäubungsfläche im Betrieb konkav ausgebildet bleibt, vorzugsweise stetig gekrümmt.

7. Quelle nach einem der Ansprüche 1 bis 6, dadurch gekennzeichnet, dass der magnetische Kreis so ausgebildet ist, dass eine Richtcharakteristik bezüglich abgestäubter Teilchen der Zerstäubungsfläche auf die Aufnahmeöffnung (11) während des Zerstäubungsbetriebes im wesentlichen gleich erhalten bleibt.

8. Quelle nach einem der Ansprüche 1 bis 7, für die Beschichtung einer zentrumsabzudeckenden Werkstückscheibe, dadurch gekennzeichnet, dass ein Maskierungskern (15) zentral durch den Targetkörper bis auf die Höhe der Aufnahmeöffnung (11) ragt.

9. Quelle nach einem der Ansprüche 1 bis 8, dadurch gekennzeichnet, dass bezüglich der Zerstäubungsfläche zentral Gasauslässe (37) für ein Prozessgas vorgesehen sind.

10. Quelle nach einem der Ansprüche 1 bis 9, dadurch gekennzeichnet, dass der grösste Abstand zwischen der Zerstäubungsneufläche und der Ebene der Aufnahmeöffnung (11) bezüglich des kleinsten Durchmessers $\Phi_k$ ($\varnothing_{13}$) der Aufnahmeöffnung (11) beträgt:
- $20\% \, \Phi_k \leqq d_{113}$.

11. Quelle nach einem der Ansprüche 1 bis 10, dadurch gekennzeichnet, dass der grösste Abstand ($d_{113}$) zwischen Zerstäubungsneufläche und der Ebene der Aufnahmeöffnung (11) bezüglich des kleinsten Durchmessers $\Phi_k$ ($\varnothing_{13}$) der Aufnahmeöffnung (11) beträgt:
- $d_{113} \leqq 50\% \, \Phi_k$, dabei vorzugsweise beträgt:
- $d_{113} \leqq 42\% \, \Phi_k$,
dabei insbesondere bevorzugterweise beträgt:
- $d_{113} \leqq 35\% \, \Phi_k$.

12. Quelle nach einem der Ansprüche 1 bis 11, dadurch gekennzeichnet, dass der grösste Abstand ($d_{113}$) zwischen der Zerstäubungsneufläche und der Ebene der Aufnahmeöffnung (11) mindestens 25mm beträgt, vorzugsweise zwischen 30mm und 55mm beträgt, vorzugsweise zwischen 30mm und 35mm.

13. Quelle nach einem der Ansprüche 10 bis 12, dadurch gekennzeichnet, dass die Aufnahmeöffnung kreisrund ist, vorzugsweise einen Durchmesser ($\varnothing_{13}$) von 50mm bis 150mm, vorzugsweise von 75mm bis 150mm, aufweist.

14. Quelle nach einem der Ansprüche 1 bis 13, dadurch gekennzeichnet, dass der oder die Durchmesser der Zerstäubungsfläche 30% bis 40% grösser ist bzw. sind als der bzw. die Durchmesser ($\varnothing_{13}$) der Aufnahmeöffnung (11).

15. Quelle nach einem der Ansprüche 1 bis 14, für kreisförmige Werkstückscheiben, dadurch gekennzeichnet, dass der Aufnahmering (9) parallel zur Ebene der Aufnahmeöffnung (11) eine Breite $\Delta$ aufweist von:
- $0 \leqq \Delta \leqq 20\% \varnothing_k$, vorzugsweise von
- $0 \leqq \Delta \leqq 10\% \varnothing_k$, vorzugsweise
- ca. 15% $\varnothing_k$

des kleinsten Werkstückdurchmessers $\varnothing_k$ beträgt.

16. Quelle, nach einem der Ansprüche 1 bis 15, dadurch gekennzeichnet, dass die Innenfläche ($F_9$) des Aufnahmeringes (9) senkrecht zur Ebene (E) der Aufnahmeöffnung (11) eine Tiefe a aufweist, die bezüglich des maximalen Abstandes zwischen Zerstäubungsneufläche und Oeffnungsebene der Aufnahmeöffnung (11), $d_{113}$, wie folgt dimensioniert ist:
- $a \leqq 50\% d_{113}$, dabei vorzugsweise
- $a \leqq 40\% d_{113}$

beträgt und verschwinden kann, vorzugsweise aber beträgt:
- $a \approx 30\% d_{113}$.

17. Quelle nach einem der Ansprüche 1 bis 16, dadurch gekennzeichnet, dass mindestens ein Teil des Aufnahmerahmens (9) auf ein Bezugspotential, vorzugsweise auf ein einstellbares Bezugspotential gelegt ist, vorzugsweise auf ein anodisches, oder floatend betrieben ist.

18. Quelle, nach einem der Ansprüche 1 bis 17, dadurch gekennzeichnet, dass die Beschichtungsrate während der Standzeit des Targetkörpers (1) um weniger als 50% der Neurate abnimmt, vorzugsweise um weniger als 35%.

19. Quelle, nach einem der Ansprüche 1 bis 18, dadurch gekennzeichnet, dass an Orten, an denen keine Entladungen erwünscht sind und hohe magnetische Feldstärken herrschen, eine elektrische Isolation vorgesehen ist, wie z.B. an Dunkelräumen.

20. Verwendung der Zerstäubungsquelle nach einem der Ansprüche 1 bis 19 für das Zerstäubungsbeschichten von Speicherscheiben, insbesondere von CDs.

## Claims

1. Magnetron sputtering source with a target body (1) whose sputtering surface (3) is designed concave in at least one plane from the edge of the body along a mirror image symmetry, with a magnetic circuit arrangement (4, 40, 41, 42, 44) which generates a magnetic field (B) above the sputtering surface (3), also with an anode arrangement (15, 9), a holding frame (9) running around the edge of the target body (1) and insulated electrically from this with a holder opening (11) for at least one work piece to be coated (13), where on the source side the process chamber is essentially limited only by the sputtering surface (3) of the target body (1) and the inner surface ($F_9$) of the holding frame (9), characterised in that the process chamber - apart from a holding opening (11) for at least one workpiece (13) - is essentially limited by the sputtering surface (3), the peripheral non-sputtered remaining inner surface ($F_9$) is reduced to the relevant minimum which in operation guarantees a stable plasma discharge.

2. Source according to Claim 1, characterised in that for the remaining inner surface ($F_9$), as for example that of the holder ring (9) and the sputtering surface ($F_1$) of the target body:
- $F_9 \leqq 50\% F_1$ preferably
- $F_9 \leqq 40\% F_1$ in particular
- $F_9 \leqq 30\% F_1$

3. Sources according to any of Claims 1 or 2, characterised in that the magnetic circuit arrangement (4, 40, 41, 42, 44) is switched to the electrical potential of the target body (1).

4. Source according to any of Claims 1 to 3, characterised in that the new sputtering surface (3) is formed pointing against the holder opening (11), in particular as a paraboloid or spherical surface.

5. Source according to any of Claims 1 to 4, characterised in that sputtering surface is circular, oval or rectangular, preferably circular, viewed from the front.

6. Source according to any of Claims 1 to 5, characterised in that the magnetic circuit is designed such that the sputtering surface remains concave in operation, preferably constantly curved.

7. Source according to any of Claims 1 to 6, characterised in that magnetic circuit is designed such that a directional characteristic for the eroded particles of the sputtering surface on the holder opening (11) is held essentially constant during the sputtering process.

8. Source according to any of Claims 1 to 7, for coating a work piece disc covering the centre, characterised in that a masking core (15) projects centrally through the target body to the depth of the holder opening (11).

9. Source according to any of Claims 1 to 8, characterised in that with regard to the sputtering surface, central gas outlets (37) are provided for a process gas.

10. Source according to any of Claims 1 to 9, characterised in that the greatest distance between the new sputtering surface and the plane of the holder opening (11) in relation to the smallest diameter $\phi_k$ ($0_{13}$) of the holder opening (11) is
    - $20\% \ \phi_k \leqq d_{113}$.

11. Source according to any of Claims 1 to 10, characterised in that the greatest distance ($d_{113}$) between the new sputtering surface and the plane of the holder opening (11) in relation to the smallest diameter $\phi_k$ ($0_{13}$) of the holder opening (11) is:
    - $d_{113} \leqq 50\% \ \phi_k$, where preferably
    - $d_{113} \leqq 42\% \ \phi_k$,
    where in particular preferably:
    - $d_{113} \leqq 35\% \ \phi_k$.

12. Source according to any of Claims 1 to 11, characterised in that the greatest distance ($d_{113}$) between the new sputtering surface and the plain of the holder opening (11) is at least 25 mm, preferably between 30 mm and 55 mm preferably between 30 mm and 35 mm.

13. Source according to any of Claims 10 to 12, characterised in that the holder opening is circular, preferably has a diameter ($0_{13}$) of 50 mm to 150 mm, preferably 75 mm to 150 mm.

14. Source according to any of Claims 1 to 13, characterised in that the diameter or diameters of the sputtering surface is or are 30 - 40% greater than the diameter or diameters ($0_{13}$) of the holder opening (11).

15. Source according to any of Claims 1 to 14, for a circular workpiece disc, characterised in that the holder ring (9) parallel to the plane of the holder opening (11) has a width $\Delta$ of:
    - $0 \leqq \Delta \leqq 20\% \ \phi_k$, preferably
    - $0 \leqq \Delta \leqq 10\% \ \phi_k$, preferably
    - approximately $15\% \ \phi_k$
    of the smallest work piece diameter $\phi_k$.

16. Source according to any of Claims 1 to 15, characterised in that the inner surface ($F_9$) of the holder ring (9) vertical to plane (E) of the holder opening (11) has a depth a which in relation to the maximum distance between the sputtering new surface and the opening plane of the holder opening (11), $d_{113}$, is dimensioned as follows:
    - $a \leqq 50\% \ d_{113}$, where preferably

- $a \leqq 40\% \, d_{113}$,

and can disappear, but preferably:

- $a \approx 30\% \, d_{113}$.

**17.** Source according to any of Claims 1 to 16, characterised in that at least one part of the holder frame (9) has a reference potential, preferably an adjustable reference potential, preferably an anodic or floating operation.

**18.** Source according to any of Claims 1 to 17, characterised in that the coating rate during the standing time of the target body (1) decreases by less than 50% of the new rate, but preferably by less than 35%.

**19.** Source according to any of Claims 1 to 18, characterised that at points at which no discharge is desired and where high magnetic field strengths predominate an electrical isolation is provided eg. at dark areas.

**20.** Use of a sputtering source according to any of Claims 1 to 19 for sputtering coating of memory discs, in particular CDs.


**Revendications**

**1.** Source de pulvérisation par magnétron comportant un corps cible (1) dont la surface de pulvérisation (3) présente, à partir du bord dudit corps, une forme concave symétrique par rapport à au moins un plan, un dispositif de circuit magnétique (4, 40, 41, 42, 44) qui génère un champ magnétique (B) au-dessus de la surface de pulvérisation (3), un dispositif d'anode (15, 9), et un bâti de réception (9) faisant le tour du bord du corps cible (1), isolé électriquement par rapport à celui-ci et pourvu d'une ouverture de réception (11) pour au moins une pièce à revêtir (13), étant précisé que côté source, l'espace de traitement est délimité sensiblement exclusivement par la surface de pulvérisation (3) du corps cible (1) et par la surface intérieure ($F_9$) du bâti de réception (9),

caractérisée en ce que l'espace de traitement, exception faite d'une ouverture de réception (11) prévue pour au moins une pièce (13), est sensiblement délimité par la surface de pulvérisation (3), et la surface intérieure restante ($F_9$) circulaire non pulvérisée est réduite au minimum qui garantit, en marche, une décharge de plasma stable.

**2.** Source selon la revendication 1, caractérisée en ce que les valeurs applicables pour la surface intérieure restante ($F_9$) comme par exemple celle de la bague de réception (9), et la surface de pulvérisation $F_1$ du corps cible, sont les suivantes :
- $F_9 \leqq 50 \% \, F_1$, de préférence
- $F_9 \leqq 40 \% \, F_1$, et en particulier
- $F_9 \leqq 30 \% \, F_1$.

**3.** Source selon l'une des revendications 1 ou 2, caractérisée en ce que le dispositif de circuit magnétique (4, 40, 41, 42, 44) est mis au potentiel électrique du corps cible (1).

**4.** Source selon l'une des revendications 1 à 3, caractérisée en ce que la surface neuve de pulvérisation (3) est conçue pour être dirigée vers l'ouverture de réception (11), par exemple sous la forme d'une surface en forme de paraboloïde ou sphérique.

**5.** Source selon l'une des revendications 1 à 4, caractérisée en ce que la surface de pulvérisation, vue de dessus, est circulaire, ovale ou rectangulaire, de préférence circulaire.

**6.** Source selon l'une des revendications 1 à 5, caractérisée en ce que le circuit magnétique est conçu de telle sorte que la surface de pulvérisation reste concave, en marche, de préférence toujours courbe.

**7.** Source selon l'une des revendications 1 à 6, caractérisée en ce que le circuit magnétique est conçu de telle sorte qu'une caractéristique directive par rapport aux particules pulvérisées de la surface de pulvérisation sur l'ouverture de réception (11) reste sensiblement identique pendant la pulvérisation.

**8.** Source selon l'une des revendications 1 à 7 pour le revêtement d'une pièce en forme de plaque à couvrir

EP 0 676 791 B1

en son centre, caractérisée en ce qu'un mandrin de masquage (15) traverse le corps cible, au centre, jusqu'à la hauteur de l'ouverture de réception (11).

**9.** Source selon l'une des revendications 1 à 8, caractérisée en ce que des sorties de gaz (37) pour un gaz de traitement sont prévues de façon centrale par rapport à la surface de pulvérisation.

**10.** Source selon l'une des revendications 1 à 9, caractérisée en ce que l'écartement maximum entre la surface neuve de pulvérisation et le plan de l'ouverture de réception (11), par rapport au diamètre minimum $\phi_k$ ($\varnothing_{13}$) de ladite ouverture de réception (11), est :
- 20 % $\phi_k \leqq d_{113}$.

**11.** Source selon l'une des revendications 1 à 10, caractérisée en ce que l'écartement maximum ($d_{113}$) entre la surface neuve de pulvérisation et le plan de l'ouverture de réception (11), par rapport au diamètre minimum $\phi_k$ ($\varnothing_{13}$) de ladite ouverture de réception (11), est :
- $d_{113} \leqq 50 \% \phi_k$, de préférence :
- $d_{113} \leqq 42 \% \phi_k$ et, d'une manière particulièrement préférée :
- $d_{113} \leqq 35 \% \phi_k$.

**12.** Source selon l'une des revendications 1 à 11, caractérisée en ce que l'écartement maximum ($d_{113}$) entre la surface neuve de pulvérisation et le plan de l'ouverture de réception (11) est d'au moins 25 mm, de préférence entre 30 mm et 55 mm, de préférence entre 30 et 35 mm.

**13.** Source selon l'une des revendications 10 à 12, caractérisée en ce que l'ouverture de réception est circulaire et présente de préférence un diamètre ($\varnothing_{13}$) de 50 mm à 150 mm, de préférence de 75 à 150 mm.

**14.** Source selon l'une des revendications 1 à 13, caractérisée en ce que le ou les diamètres de la surface de pulvérisation sont supérieurs de 30 % à 40 % à celui ou à ceux ($\varnothing_{13}$) de l'ouverture de réception (11).

**15.** Source selon l'une des revendications 1 à 14 pour des pièces en forme de plaques circulaires, caractérisée en ce que la bague de réception (9) présente, parallèlement au plan de l'ouverture de réception (11), une largeur $\Delta$ de :
- $0 \leqq \Delta \leqq 20 \% \varnothing_k$, de préférence de
- $0 \leqq \Delta \leqq 10 \% \varnothing_k$, et qui est de préférence égale à
- environ 15 % $\varnothing_k$
du diamètre de pièce minimum $\varnothing_k$.

**16.** Source selon l'une des revendications 1 à 15, caractérisée en ce que la surface intérieure ($F_9$) de la bague de réception (9) présente, perpendiculairement au plan (E) de l'ouverture de réception (11), une profondeur a qui est dimensionnée par rapport à l'écartement maximum $d_{113}$ entre la surface neuve de pulvérisation et le plan de l'ouverture de réception (11) de la façon suivante :
- $a \leqq 50 \% d_{113}$, de préférence
- $a \leqq 40 \% d_{113}$,
et qui peut être infiniment petite, mais qui est de préférence la suivante :
- $a \approx 30 \% d_{113}$.

**17.** Source selon l'une des revendications 1 à 16, caractérisée en ce qu'une partie au moins du bâti de réception (9) est mise à un potentiel de référence, de préférence à un potentiel de référence réglable, de préférence anodique, ou est commandée de façon flottante.

**18.** Source selon l'une des revendications 1 à 17, caractérisée en ce que la vitesse de revêtement pendant la durée de vie du corps cible (1) diminue de moins de 50 % de la vitesse nouvelle, de préférence de moins de 35 %.

**19.** Source selon l'une des revendications 1 à 18, caractérisée en ce qu'il est prévu, aux endroits où on ne souhaite pas de décharges et où règnent des intensités de champ magnétique élevées, une isolation électrique, par exemple dans des espaces sombres.

**20.** Utilisation de la source de pulvérisation selon l'une des revendications 1 à 19 pour le revêtement par pulvérisation de disques numériques, en particulier de CD.

10

FIG.1

FIG.2